# EUROPEAN PATENT SPECIFICATION

(11) **EP 0 678 909 B1**
(45) Date of publication and mention of the grant of the patent: **14.07.1999**
(21) Application number: 94830187.4
(22) Date of filing: 20.04.1994
(51) Int. Cl.: H01L 21/66

(54) **Monitoring of rf-plasma induced potential on a gate dielectric inside a plasma etcher**
Beobachtung des RF-Plasmainduzierten Potentials auf einem Gatterdielektrikum innerhalb eines Plasmaätzers
Suivi d'une tension induite par un plasma RF sur un diélectrique de porte dans un appareil de gravure par plasma

(43) Date of publication of application: 25.10.1995
(73) Proprietor: STMicroelectronics S.r.l., 20041 Agrate Brianza (Milano) (IT)
(72) Inventor: Maccagno, Pierre, 22059 Robbiate (IT)
(74) Representative: Pellegri, Alberto

(56) References cited:
- US-A- 5 179 433
- 1992 IEEE/SEMI Advanced Semiconductor Manufacturing Conference, September 30- October 1, 1992, Cambridge, Massachusetts, pp. 148-152, W. LUKASZEK ET AL.: "CHARM2: Towards an Industry-Standard Wafer Surface-Charge Monitor"
- PATENT ABSTRACTS OF JAPAN vol. 16, no. 441 (E-1264) 14 September 1992 & JP-A-04 154 143 (NEC)
- ICMTS 93, IEEE, March 22-25, 1993, Sitges, Barcelona, Spain, pp.149-154, Y. URAOKA ET AL.: "Evaluation Technique of Gate Oxide Damage"
- DATABASE WPI Week 9412, Derwent Publications Ltd., London, GB; AN 94-095071 & JP-A-6 043 138 (SONY)
- PATENT ABSTRACTS OF JAPAN vol. 13, no. 164 (E-745) 19 April 1989 & JP-A-63 316 439 (FUJI ELECTRIC)
- PATENT ABSTRACTS OF JAPAN vol. 14, no. 346 (E-0956) 26 July 1990 & JP-A-02 119 159 (HITACHI)
- Solid State Technology, June 1992, pages 81-87, C.T. Gabriel, J.P. McVittie: "How Plasma Etching Damages Thin Gate Oxides"

## Description

In general the present invention relates to plasma etching techniques of layers and/or stacks of layers on wafers, in semiconducting devices fabrication processes. In particular, the invention relates to an improved monitoring system of the potential that may be induced locally on the face of the wafer, because of electric charge accumulations (local imbalances of the ionic flux) during radio frequency (RF) plasma treatments, through the detection of effects caused by overpotentials on sensitive structures.

The accumulation of electrical charge, induced by an RF activated plasma on certain structures that may act as charge collectors or "antennas", during plasma etching of layers present on the surface of a wafer, is recognised as responsible for a certain degradation of the dielectric properties of thin gate dielectric layers that may be subjected to different electric stresses in different zones or areas of the surface of the wafer exposed to plasma etching. These effects may have a marked variability from point to point of the surface of the wafer exposed to an RF activated plasma. The magnitude of the different, localized, electrical charge accumulations is difficult to derive through mathematical models based on basic principles because the mechanisms that are responsible for plasma disuniformities are very complex.

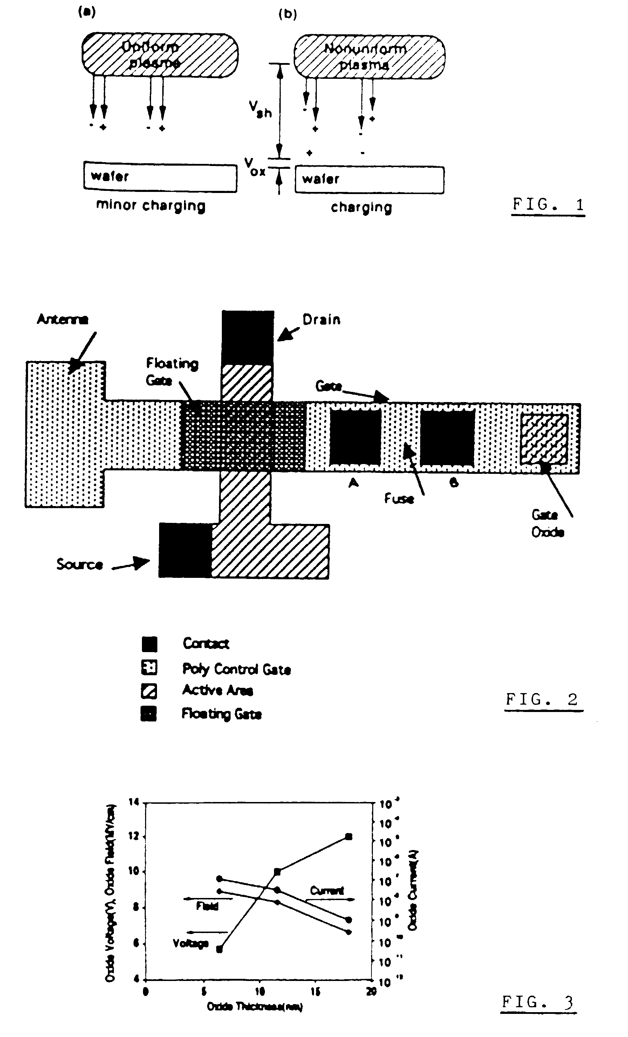

Nonuniformities of an RF activated plasma within a reactor produces localized imbalances of ionic and electronic fluxes incident the surface of a wafer subjected to plasma etching, during every RF cycle, as schematically depicted in Fig. 1. Although these flux imbalances balance themselves out over the total area of the electrode chuck of the reactor, there are regions through which a current or flux with a negative net charge, due to a dominant electronic component, may occur and other regions where a current or flux with a positive net charge may occur, due to a prevailing ionic component. In these conditions, when the surface of the wafer immersed in the RF electromagnetic field is nonconductive, localized charge accumulations will occur until the accumulated charge is balanced out by continuously changing electromagnetic flux distribution.

If the treated wafer contains dielectric layers sufficiently thin to conduct according to the so-called Fowler-Nordheim (FN) mechanism, the potential induced through the dielectric layer by the electromagnetic field may be sufficiently high as to generate a net FN electric current through the dielectric layer, which may equal the net plasmatic current locally intercepted by the surface of the wafer, or by a conductive feature thereof acting as a charge collector or local antenna. The magnitude of such an FN current will depend greatly on the thickness of the dielectric layer.

Therefore in these cases it is important to gather a measure of the magnitude of the electrical charging that may be locally induced by the plasma, taking into account the thickness of a certain gate dielectric layer (notably capable of conducting current through the FN mechanism).

In order to monitor the peak potential induced by an RF activated plasma and indirectly establishing a measure of the degradation that may be caused in devices treated with a particular reactor under certain plasma etching conditions, several different techniques have been developed.

A first technique employs a Langmuir probe. Such a classical method is scarcely used in semiconductor devices fabrication processes because it substantially represents an invasive technique, hardly compatible with other process requirements.

The so-called capacitors technique consists in fabricating a plurality of capacitors, in different points of the surface of a wafer, the dielectric of which (a gate dielectric layer for example) is exposed to the particular conditions of a plasma etching treatment to be monitored. Similar pluralities of capacitors are fabricated on reference or blank wafers using a wet technique. The magnitude of the FN current through the gate dielectric layer of the capacitors exposed to the plasma is determined through a comparison between quasi-static CV characteristics of the capacitors subjected to plasma exposure with those of capacitors fabricated by a wet technique, which have been subjected to different levels of constant FN current for a period of time corresponding to the period of plasma treatment for the contemplated fabrication step. The pair of most similar or identical CV curves, one corresponding to the one obtained for a plasma exposed capacitor and the other corresponding to one of the wet formed capacitors of a reference wafer having the same thickness of gate dielectric and stressed at a certain known FN current, are identified by comparison. At this point, the assumption made is that the FN current that has actually flown through the plasma exposed capacitor has the value of the FN current flown through the wet formed, reference capacitor.

A limitation of this method is that it assumes that the dielectric layer of the capacitors be exposed to the potential induced by the plasma for the entire duration of the contemplated plasma treatment. This certainly does not correspond to reality. In view of this assumption, the wet treated capacitors are subjected to a certain constant conditioning FN current (stressed) for a period of time that is markedly longer than the period of "electrical stress" to which a plasma exposed capacitor is effectively subjected.

Therefore, in comparing the CV curves of the plasma exposed capacitors and of the reference, wet treated capacitors, subjected to a pre-defined electrical stress (current x time), the estimation of the FN current that has actually flown through the capacitors during plasma exposition could result markedly underestimated.

A further limitation of this method is that the wet formed, reference capacitors must necessarily be preconditioned. In so doing it is assumed that the quality of the dielectric of both types of capacitors, that is of the wet formed capacitor and of the plasma exposed capacitor be comparable, which may not be true.

Another drawback of this known method is due to the fact that it does not permit to derive any indication of the real density of the current induced by the plasma, because the charge intercepting area of the capacitor is generally not known.

Finally, another limitation is due to the fact that the FN current through a dielectric layer being electrically stressed at a constant potential may vary in time as a consequence of a progressive degradation of the quality of the dielectric. Also this aspect makes it difficult to reliably determine the magnitude of the potential induced by the plasma across a dielectric layer.

An alternative known technique for establishing in an indirect way the potential induced by an RF activated plasma employs as sensing structure a known EEPROM cell structure. By employing this type of sensing structure it is possible to measure the peak potential induced by the plasma on the surface of the wafer during exposure to an RF activated plasma, at different points of the surface of a wafer, by forming in these positions a test EEPROM structure.

The document 1992 IEEE/SEMI Advanced Semiconductor Manufacturing Conference, Sept-Oct 1992, pages 148-152, W. Lukaszek et al.: "Charm 2: Towards an industry-standard wafer surface-charge monitor", describes the criteria and the experiments undertaken to develop an industry standard surface charge monitor wafer, employing EEPROM-based test structures to check the driving forces behind charging damage associated with ion- and plasma-based IC processes.

The document Solid state Technology, June 1992, pages 81-87, C.T. Gabriel, J.P. McVittie: "How Plasma Etching Damages Thin Gate Oxides" indicates how certain structures that may act as charge collector or "antennas" during plasma etching steps, produce an accumulation of electrical charge induced by RF activated plasma responsible for the observed degradation of the dielectric properties of thin gate oxide layers.

On the other hand it is fundamental to note that the measured potental is the potential at which an essentially non conductive dielectric layer (such as the one that capacitively couples a control gate to a floating gate of an EEPROM cell) charges when exposed to the plasma.

The measuring technique consists in exposing a probe wafer having EEPROM cells distributed over the entire surface thereof to the plasma. The probe wafer is normally preventively irradiated with UV light, in order to place all the EEPROM cells at an identical floating gate potential.

The pads defined on the probe wafer for allowing the contact with a test probe tip to carry out the electrical measurements, which are connected to the source and drain respectively of each EEPROM cell, may be protected with a resist layer or a layer of another dielectric material in order to prevent charging the source and drain regions during plasma exposition. Moreover, the metallization layer on the back of the probe wafer should be disposed in such a way as to make a good electrical contact with the plasma reactor's chuck (electrode).

Exposure to the plasma of the probe wafers may be protracted for pre-established exposure times. The potential induced by the plasma may then be determined electrically by measuring the variation of the threshold voltage δ Vₜₕ, as a function of the time of exposure to the plasma. The characteristic curves thus obtained for each cell may then be compared with similar characteristic curves obtained by electrically stressing the EEPROM cells with different control gate voltages V_{g}, for certain periods of time, while maintaining V_{source} = V_{drain} = V_{body} = 0. The potential induced by the plasma (V_{g}) may be determined by identifying which of the reference curves obtained by stressing under predefined conditions the various cells, correspond to a particular characteristic curve of each one of the EEPROM cells of a probe wafer exposed to the plasma.

In order to facilitate the reaching of equilibrium conditions in the shortest period of time, the antenna area (that is the area of interception of the flux of electrical charges of the control gate of a cell) may be incremented.

This method of measuring/monitoring, has a drawback represented by the fact that it determines essentially the peak value of the potential induced by the plasma on a nonconducting of dielectric layer, such as the one that isolates the control gate from the floating gate of the sensing EEPROM structure, for example of a O-N-O (Oxide-Nitride-Oxide) stack. Viceversa, a gate oxide that conducts through a Fowler-Nordheim mechanism (FN) is subjected to electrical stess also with a plasma induced potential smaller than the peak potential determined by the above described method.

Therefore there is a need and/or utility for an improved monitoring method which permits to derive with a good approximation the value of the potential induced by the plasma as a function of a certain thickness of a gate dielectric layer that is capable of conducting according to a Fowler-Nordheim mechanism.
By knowing with relative precision the value of the potential induced by the plasma, the FN current induced by the plasma through a gate dielectric may also be precisely determined. This may be easily done by applying the same potential induced by the plasma to a capacitor having as a dielectric a gate dielectric layer of identical thickness and by measuring the resulting current.

These objectives are achieved by the method of the present invention as given in claim 1 which allows to determine with excellent precision the potential induced by the plasma on a FN-conducting dielectric layer, by employing as sensing structure a probe as given in claim 7 comprising an EEPROM cell, the control gate of which is connected to a capacitor that employs as dielectric a gate dielectric layer of known thickness during exposure to the plasma and by interrupting such a connection before performing the electric measurement of the threshold voltage of the plasma exposed a EEPROM cell.

By employing probe wafers, each having a certain gate dielectric layer thickness, used as dielectric of the capacitors that are associated (connected) to the control gate of respective sensing EEPROM cells, it is possible to determine the potential induced by the plasma as a function of the thickness of the dielectric layer of the capacitors associated to the sensing EEPROM structures. The potential induced by the plasma will result smaller for a thinner gate dielectric thickness of the associated capacitors.

Substantially, the above-noted limitation of the sensing EEPROM cell structures of the known method is obviated by associating to each of them, during plasma exposition, a capacitor that reproduces the condition of an intervening FN current, not otherwise present through the dielectric layer of the sensing EEPROM cells. Practically no current flows through the dielectric layer that isolates the control gate (exposed to the plasma) and the floating gate of the EEPROM cell. Therefore, the maximum plasma induced potential on a certain sensing EEPROM cell will be conditioned by the magnitude of the FN current that flows through the gate dielectric layer of the capacitor that is electrically connected to the control gate of the sensing EEPROM cell.

Of course, after exposure to the plasma, it is necessary to determine the variation of the threshold voltage of the exposed sensing EEPROM cell. In order to do that it must be possible to apply a certain potential to the control gate of the EEPROM cell and, in view of the fact that a leakage current or a possible breakdown of the dielectric of the capacitor, capable of conducting by a Fowler-Nordheim mechanism, may occur, the connection between the capacitor and the control gate of the EEPROM cell must be preliminarily broken. This may be easily effected by forming a fuse structure along the connection (e.g. a polyfuse).

The different aspects and advantages of the method and of the sensing structure of the present invention will become more evident through the following description of several embodiments and by referring to the attached drawings wherein:
**Figure 1** schematically shows the mechanism of induction of potentials on the surface of the wafer exposed to a disuniform plasma;
**Figure 2** is a schematic plan view of an sensing structure composed by an EEPROM cell, the control gate of which is coupled capacitively to the substrate through a gate dielectric layer of known thickness;
**Figure 3** shows the diagrams of the charge current, of the voltage and of the electric field, for three different thicknesses of a gate oxide layer.

With reference to Fig. 1, the mechanism of the induction of superficial potentials due to localized charge accumulations is depicted by showing the case of a uniform plasma (wherein flux tubes are perfectly balanced) and the case of a nonuniform plasma characterised by localized charged streams with a predominant positive or negative component and which therefore is capable of inducing potentials of remarkable value on the surface of the wafer. The Vₛₕ represents the so-called "sheath" voltage, while the Vₒₓ represents the voltage induced through a gate oxide layer present on the wafer.

The sensing structure of the invention is shown in a schematic manner in the layout of Fig. 2. The sensing structure is essentially that of an EEPROM cell, the control gate of which, beside acting as an antenna, is capacitively coupled to the semi-conducting substrate of the wafer through a gate oxide layer (i.e. connected to a capacitor having as dielectric a gate oxide layer of known thickness).

A polyfuse structure, suitable for interrupting the connection between the control gate of the EEPROM cell and the associated capacitor is implemented by forming two contact pads A and B respectively along the control gate, between the EEPROM cell structure and the capacitor (area of capacitive coupling of the extended control gate strip with the substrate).

Only a certain defined area of interception or of antenna (electrically connected to the control gate of the cell) may be exposed to the plasma. The source and drain contacts (pads) and the other parts of the surface of the probe wafer should preferably be shielded from the plasma by protecting them (covering them) with a nonconductive layer, for example of a resist, in order to ensure that I_{drain}=V_{source}=0V during exposure.

After exposing the probe wafer to the plasma, the connection between each EEPROM cell and its associated capacitor are interrupted by applying through the two contacts A and B a voltage sufficient to determine a local current of a value sufficient to break the gate polysilicon between the two contacts A and B (polyfuse). This may be carried out by connecting to ground potential (V=0) the A contact (next to the sensing EEPROM cell) and applying a sufficiently high voltage to the contact B (next to the capacitor).

The potential induced by the plasma may then be determined by measuring the threshold voltage (δ Vₜₕ) of the sensing EEPROM cells, according to common measuring techniques.

By providing, in accordance with the objective of the invention, by the capacitive coupling of the control gate of the cell, the possibility of discharging through an FN current, the sensing structure of the invention becomes dependent on the intercepting area (antenna area). For this reason, the sensing structures must be normalized in terms of antenna area, so that the charge current density induced by the plasma remains dependent exclusively on the thickness of the gate dielectric layer of the capacitor associated with the sensing EEPROM cell.

The diagrams of Fig. 3 show the determined values of the charge current, of the voltage and of the electric field for three different thicknesses of the gate oxide layer. In perfect agreement with the premises, the induced voltage results are markedly different for different thicknesses of the gate oxide layer.

The sensibility of the sensing structure of the invention may be incremented by increasing the α_{g} parameter that represents the capacitive coupling between the control gate and the floating gate of the sensing EEPROM cell structure. In practice, the potential through the tunnelling oxide of an EEPROM cell may have its maximum value given by the product: V_{g} α_{g}.

For increasing sensibility, α_{g} may be incremented by increasing the lenght W_{g} of the cell.

Another technique for increasing sensibility, may be that of implementing the "antenna" with a conductive material that is not readily etched by the plasma; in this way the EEPROM cell maybe exposed to the plasma for a longer period.

## Claims

1. A method for measuring the charging of dielectric layers induced by an RF activated plasma by employing as a probe a wafer having a plurality of EEPROM cells distributed over its surface, which comprises exposing the wafer to the plasma and subsequently measuring the threshold voltage assumed by the single EEPROM cells as an indication of the maximum potential induced locally by the plasma, characterized by
maintaining the control gate of each EEPROM cell capacitively coupled with the semiconducting substrate of the wafer through a dielectric gate layer of the same known thickness as the dielectric gate layer of its respective EEPROM cell during exposition to the plasma and by interrupting said capacitive coupling before measuring the threshold voltage of the cell.

2. A method as defined in claim 1, wherein the charge current density induced by the plasma through said gate dielectric layer is measured by applying a potential equal to the determined plasma induced potential according to the procedure of claim 1 to a capacitor having as a dielectric a gate dielectric layer of identical thickness to that of the gate dielectric layer employed in the procedure of claim 1 and measuring the resulting current.

3. The method of claim 1 further comprising the steps of
connecting the control gate of each sensing EEPROM cell to the armature laying over said gate dielectric layer of one of said capacitors through polyfuse means; and
interrupting said connection by breaking said polyfuse means after having exposed the probe wafer to the plasma and before measuring the threshold voltage assumed by the EEPROM cells.

4. The method as defined in claim 3, characterized by employing a plurality of probe wafers, each employing a different thickness of gate dielectric layer.

5. The method as defined in claim 3, wherein to each EEPROM cell is associated an antenna composed of a conducting layer having a predefined area exposed to the plasma, connected to the control gate of the EEPROM cell and to the armature of the capacitor associated to the cell.

6. The method as defined in claim 5, wherein other parts of the wafer, with the exception of said antenna area, are shielded by a nonconductive layer during exposition of the probe wafer to the plasma.

7. A probe for measuring the charging of dielectric gate layers induced by a plasma in the form of a probe wafer having a plurality of sensing EEPROM cells distributed over its surface, characterized by the fact that
each of said EEPROM cells has an extended control gate;
a capacitor being constituted by a first portion of said extended control gate coupled through a gate dielectric layer having the same thickness as the dielectric gate layer of the respective EEPROM cell to the underlying electrically conducting substrate;
fuse means being present along a second portion of said extended control gate between said EEPROM cell and said capacitor electrically associated therewith.

8. A probe wafer as defined in claim 7, wherein said fuse means comprise two contactable pads formed along said second portion of extended control gate between the EEPROM cell and said capacitor associated therewith.

9. A probe wafer as defined in claim 7, wherein said extended control gate has a third portion of a predefined area exposed to the plasma, while all the other portions of the wafer are shielded from the plasma by a non conductive dielectric layer.

10. A probe wafer as defined in claim 9 wherein said shielding layer is a resist layer.

11. A probe wafer as defined in any of the claims 9 and 10, wherein said exposed portion of predefined area is of a material resistant to plasma etching.

## Patentansprüche

1. Verfahren zum Messen der Ladung von dielektrischen Schichten, die durch ein HF-aktiviertes Plasma induziert wird, durch Verwenden eines Wafers mit mehreren EEPROM-Zellen, die über dessen Oberfläche verteilt sind, als eine Probe, wobei das Verfahren das Aussetzen des Wafers dem Plasma und das anschließende Messen der Schwellenspannung, die die einzelnen EEPROM-Zellen annehmen, als eine Anzeige des maximalen vom Plasma lokal induzierten Potentials umfaßt,
gekennzeichnet durch
Halten der kapazitiven Kopplung des Steuer-Gates jeder EEPROM-Zelle mit dem Halbleitersubstrat des Wafers über eine dielektrische Gate-Schicht mit der gleichen Dicke wie die dielektrische Gate-Schicht ihrer jeweiligen EEPROM-Zelle während der Plasmaexposition und Unterbrechen der kapazitiven Kopplung vor dem Messen der Schwellenspannung der Zelle.

2. Verfahren nach Anspruch 1, bei dem die vom Plasma durch die Gate-Dielektrikumschicht induzierte Ladestromdichte gemessen wird durch Anlegen eines Potentials gleich dem ermittelten, vom Plasma induzierten Potential gemäß der Prozedur des Anspruchs 1 an einen Kondensator, der als Dielektrikum eine Gate-Dielektrikumschicht mit gleicher Dicke wie diejenige der Gate-Dielektrikumschicht besitzt, die in der Prozedur des Anspruchs 1 verwendet wird, und durch Messen des resultierenden Stroms.

3. Verfahren nach Anspruch 1, ferner gekennzeichnet durch die Schritte:
Verbinden des Steuer-Gates jeder Sensor-EEPROM-Zelle mit der Armatur, die über der Gate-Dielektrikumschicht eines der Kondensatoren liegt, über eine Polysilicium-Schmelzeinrichtung; und
Unterbrechen der Verbindung durch Zerstören der Polysilicium-Schmelzeinrichtung nach dem Aussetzen des Probe-Wafers dem Plasma und vor dem Messen der Schwellenspannung, die von den EEPROM-Zellen angenommen wird.

4. Verfahren nach Anspruch 2, gekennzeichnet durch das Verwenden mehrerer Probe-Wafer, die jeweils eine unterschiedliche Dicke der Gate-Dielektrikumschicht aufweisen.

5. Verfahren nach Anspruch 3, bei dem jeder EEPROM-Zelle eine Antenne zugeordnet ist, die aus einer leitenden Schicht mit einer vorgegebenen dem Plasma ausgesetzten Fläche besteht, die mit dem Steuer-Gate der EEPROM-Zelle und mit der Armatur des der Zelle zugeordneten Kondensators verbunden ist.

6. Verfahren nach Anspruch 5, bei dem andere Abschnittte des Wafers mit Ausnahme des Antennenbereichs während des Aussetzens des Probe-Wafers dem Plasma mittels einer nichtleitenden Schicht abgeschirmt sind.

7. Probe zum Messen der Aufladung von dielektrischen Gate-Schichten, die von einem Plasma induziert wird, in Form eines Probe-Wafers mit mehreren Sensor-EEPROM-Zellen, die über dessen Oberfläche verteilt sind, dadurch gekennzeichnet, daß
jede der EEPROM-Zellen ein verlängertes Steuer-Gate besitzt;
ein Kondensator gebildet wird von einem ersten Abschnitt des verlängerten Steuer-Gates, das mit einer Gate-Dielektrikumschicht mit der gleichen Dicke wie die Gate-Dielektrikumschicht der entsprechenden EEPROM-Zelle verbunden ist, und dem darunterliegenden elektrisch leitenden Substrat;
eine Schmelzvorrichtung längs eines zweiten Abschnitts des verlängerten Steuer-Gates zwischen der EEPROM-Zelle und dem elektrisch damit verbundenen Kondensator angeordnet ist.

8. Probe-Wafer nach Anspruch 7, bei dem die Schmelzeinrichtung 2 kontaktierbare Kontaktflächen umfaßt, die längs des zweiten Abschnitts des verlängerten Steuer-Gates zwischen der EEPROM-Zelle und dem zugehörigen Kondensator ausgebildet sind.

9. Probe-Wafer nach Anspruch 7, bei dem das verlängerte Steuer-Gate einen dritten Abschnitt mit einer vordefinierten Fläche besitzt, der dem Plasma ausgesetzt wird, während alle anderen Abschnitte des Wafers mittels einer nichtleitenden dielektrischen Schicht vom Plasma abgeschirmt werden.

10. Probe-Wafer nach Anspruch 9, bei dem die Abschirmungsschicht eine Resist-Schicht ist.

11. Probe-Wafer nach einem der Ansprüche 9 und 10, bei dem der exponierte Abschnitt mit vordefinierter Fläche aus einem Material besteht, das dem Plasmaätzen widersteht.

## Revendications

1. Procédé de mesure de la charge de couches diélectriques induite par un plasma activé par des radio-fréquences en utilisant comme test une tranche comportant une pluralité de cellules EEPROM réparties sur sa surface, qui consiste à exposer la tranche au plasma et à mesurer ensuite la tension de seuil prise par les cellules EEPROM individuelles en tant qu'indication du potentiel maximum induit localement par le plasma,
caractérisé par les étapes consistant à maintenir la grille de commande de chaque cellule EEPROM couplée capacitivement au substrat semiconducteur de la tranche par l'intermédiaire d'une couche diélectrique de grille de même épaisseur connue que la couche diélectrique de grille de sa cellule EEPROM respective pendant l'exposition au plasma, et à interrompre le couplage capacitif avant de mesurer la tension de seuil de la cellule.

2. Procédé selon la revendication 1, dans lequel la densité de courant de charge induite par le plasma à travers la couche diélectrique de grille est mesurée en appliquant un potentiel égal au potentiel déterminé induit par le plasma selon la procédure de la revendication 1 à un condensateur ayant comme diélectrique une couche diélectrique de grille d'épaisseur identique à celle de la couche diélectrique de grille utilisée dans la procédure de la revendication 1 et en mesurant le courant résultant.

3. Procédé selon la revendication 1, comprenant en outre les étapes suivantes :
connecter la grille de commande de chaque cellule EEPROM de détection à l'armature se trouvant au-dessus de la couche diélectrique de grille de l'un des condensateurs, par des moyens de fusible en silicium polycristallin ; et
interrompre la connexion en coupant les moyens de fusible polycristallin après avoir exposé la tranche de test au plasma et avant de mesurer la tension de seuil prise par les cellules EEPROM.

4. Procédé selon la revendication 3, caractérisé en ce qu'il consiste à utiliser plusieurs tranches de test chacune utilisant une épaisseur différente de couche diélectrique de grille.

5. Procédé selon la revendication 3, dans lequel chaque cellule EEPROM est associée à une antenne constituée d'une couche conductrice ayant une surface prédéfinie exposée au plasma, connectée à la grille de commande de la cellule EEPROM et à l'armature du condensateur associé à la cellule.

6. Procédé selon la revendication 5, dans lequel d'autres parties de la tranche, à l'exception de la zone d'antenne, sont protégées par une couche non-conductrice pendant l'exposition de la tranche de test au plasma.

7. Moyen de test pour mesurer la charge de couches diélectriques de grille induite par un plasma sous forme d'une tranche de test comportant une pluralité de cellules EEPROM de détection réparties sur sa surface, caractérisé en ce que :
chacune des cellules EEPROM comporte une grille de commande étendue ;
un condensateur est constitué d'une première partie de la grille de commande étendue couplée par une couche diélectrique de grille, ayant la même épaisseur que la couche diélectrique de grille de la cellule EEPROM respective, au substrat électriquement conducteur sous-jacent ; et
un moyen de fusible est présent le long d'une seconde partie de la grille de commande étendue entre la cellule EEPROM et le condensateur qui lui est électriquement associé.

8. Tranche de test selon la revendication 7, dans laquelle le moyen de fusible comprend deux plots contactables formés le long de la seconde partie de la grille de commande étendue entre la cellule EEPROM et le condensateur qui lui est associé.

9. Tranche de test selon la revendication 7, dans laquelle la grille de commande étendue comporte une troisième partie de surface prédéfinie exposée au plasma, tandis que toutes les autres parties de la tranche sont protégées du plasma par une couche diélectrique non-conductrice.

10. Tranche de test selon la revendication 9, dans laquelle la couche de protection est une couche de résine.

11. Tranche de test selon la revendication 9 ou 10, dans laquelle la partie exposée de surface prédéfinie est en un matériau résistant à une gravure plasma.
